(19) Europäisches Patentamt
European Patent Office
Office européen des brevets

(11) **EP 4 524 594 A1**

(12) **EUROPÄISCHE PATENTANMELDUNG**

(43) Veröffentlichungstag:
**19.03.2025   Patentblatt 2025/12**

(21) Anmeldenummer: **24200184.0**

(22) Anmeldetag: **13.09.2024**

(51) Internationale Patentklassifikation (IPC):
**G01R 33/26** (2006.01)   **G01R 33/32** (2006.01)

(52) Gemeinsame Patentklassifikation (CPC):
**G01R 33/26; G01R 33/323**

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**GE KH MA MD TN**

(30) Priorität: **14.09.2023   DE 102023208946**

(71) Anmelder: **Fraunhofer-Gesellschaft zur Förderung der angewandten Forschung e.V.**
**80686 München (DE)**

(72) Erfinder:
• **JESKE, Jan**
  **79108 Freiburg (DE)**
• **LINDNER, Lukas**
  **79108 Freiburg (DE)**
• **HAHL, Felix**
  **79108 Freiburg (DE)**
• **SCHALL, Florian Philipp**
  **79108 Freiburg (DE)**

(74) Vertreter: **Friese Goeden Patentanwälte PartGmbB**
**Widenmayerstraße 49**
**80538 München (DE)**

(54) **MAGNETFELDSENSOR UND VERFAHREN ZUR ERFASSUNG EINES MAGNETFELDES**

(57)    Die Erfindung betrifft einen Magnetfeldsensor (1) mit zumindest einem Diamant (2), welcher zumindest ein NV⁻-Zentrum enthält und mit zumindest einem optischen Resonator (3), in welchem der Diamant (2) angeordnet ist, sowie mit zumindest einem Pumplaser (4), welcher dazu eingerichtet ist, den Diamant mit Laserstrahlung mit einer Wellenlänge von etwa 480 nm bis etwa 637 nm zu beleuchten, und mit zumindest einem Messlaser (5), welcher dazu eingerichtet ist, Laserstrahlung in den Diamant (2) einzukoppeln, wobei weiterhin zumindest ein Detektor vorhanden ist, welcher dazu eingerichtet ist, die Absorption der Laserstrahlung des Messlasers (5) im Diamant (2) zu erfassen, wobei der Messlaser (5) dazu eingerichtet ist, Laserstrahlung mit einer Wellenlänge von etwa 750 nm bis etwa 1040 nm und/oder von etwa 1044 nm bis etwa 1500 nm zu erzeugen und der optische Resonator (3) eine Finesse von mehr als 200 aufweist. Weiterhin betrifft die Erfindung ein entsprechendes Verfahren zur Erfassung eines Magnetfeldes.

Fig. 4

**Beschreibung**

Die Erfindung betrifft einen Magnetfeldsensor mit zumindest einem Diamant, welcher zumindest ein NV-Zentrum enthält und mit zumindest einem optischen Resonator, in welchem der Diamant angeordnet ist, sowie mit zumindest einem Pumplaser, welcher dazu eingerichtet ist, den Diamant mit Laserstrahlung mit einer Wellenlänge von etwa 480 nm bis etwa 637 nm zu beleuchten. Weiterhin betrifft die Erfindung ein Verfahren zur Erfassung eines Magnetfeldes mit zumindest einem Diamant, welcher zumindest ein NV-Zentrum enthält, und welcher in einem optischen Resonator angeordnet ist, wobei der Diamant mit Laserstrahlung mit einer Wellenlänge von etwa 480 nm bis etwa 637 nm beleuchtet wird. Vorrichtungen und Verfahren dieser Art eignen sich zur Erfassung von Magnetfeldern.

Aus Felix A. Hahl et al.: "Magnetic-field-dependent stimulated emission from nitrogen-vacancy centers in diamond". Sci. Adv. 8, eabn7192 (2022) ist bekannt, zur Bestimmung eines Magnetfeldes zumindest einen Diamant einzusetzen, welcher zumindest ein NV-Zentrum enthält. Der Diamant befindet sich in einem optischen Resonator und wird mit grünem Licht aus einer Pumplichtquelle bestrahlt. Der Diamant zeigt eine magnetfeldabhängige Photolumineszenz, wobei durch den den Diamant umgebenden optischen Resonator eine stimulierte Emission bewirkt werden kann. Da die Emission mit zunehmenden Magnetfeld abnimmt, kann aus der Messung der Intensität des stimuliert emmitierten Lichtes die Stärke des Magnetfeldes bestimmt werden. Der maximal erreichbare Kontrast liegt bei 33 % oder weniger.

Ausgehend vom Stand der Technik liegt der Erfindung somit unter anderem die Aufgabe zugrunde, eine Magnetfeldmessung mit größerer Sensitivität zu ermöglichen.

Gemäß einem Aspekt der Erfindung wird ein Magnetfeldsensor vorgeschlagen. Der Magnetfeldsensor enthält zumindest einen Diamant, welcher zumindest ein NV-Zentrum enthält. Das NV-Zentrum kann ein negativ geladenes NV--Zentrum sein. In einigen Ausführungsformen der Erfindung kann eine Mehrzahl von NV-Zentren im Diamant vorhanden sein. Der Diamant kann poly- oder monokristallin sein. Der Diamant kann ein künstlich hergestellter HPHT-Diamant oder ein in einer Niederdrucksynthese erhaltener CVD-Diamant sein. In einigen Ausführungsformen der Erfindung ist der Diamant nominal undotiert und enthält möglichst wenige Verunreinigungen bzw. Störstellen.

In einigen Ausführungsformen der Erfindung befindet sich der Diamant in zumindest einem optischen Resonator. Der optische Resonator wird durch zumindest zwei gegenüberliegende Spiegel gebildet, welche ein zwischen den Spiegeln liegendes Volumen einschließen. Zumindest einer der Spiegel kann teildurchlässig sein, sodass durch den Spiegel Licht in den Resonator ein- oder ausgekoppelt werden kann. Die Spiegel können

nen Planspiegel sein oder eine konkave Form aufweisen. Durch mehrfache Reflexion von Licht innerhalb des Resonators können sich stehende Wellen im Resonator ausbilden, deren Wellenlänge durch die Eigenmoden bzw. die Resonanzfrequenz des Resonators gegeben ist. Für die Zwecke der vorliegenden Erfindung befindet sich der Diamant innerhalb des optischen Resonators, wenn dieser sich zumindest zum Teil im Strahlengang des Resonators befindet.

Die Vorrichtung kann weiterhin zumindest einen Pumplaser enthalten, welcher dazu eingerichtet ist, den Diamant mit Laserstrahlung mit einer Wellenlänge von etwa 480 nm bis etwa 637 nm zu beleuchten. Hierzu kann das Licht des Pumplasers durch zumindest einen Spiegel des Resonators in den Resonator und den darin befindlichen Diamant eingekoppelt werden. Hierbei kann der Strahlengang des Pumplasers in etwa auf der Längsachse des Resonators liegen, d. h. die Längsachse und der Pumplaser können einen Winkel von etwa -5° bis etwa +5° einschließen. In anderen Ausführungsformen der Erfindung kann der Winkel zwischen dem Laserstrahl des Pumplasers und der Längserstreckung des Resonators auch größer sein und beispielsweise zwischen etwa 20° und etwa 90° betragen. Das Licht des Pumplasers kann in diesem Fall am Resonatorspiegel vorbei unmittelbar in den Diamant eingekoppelt werden.

Weiterhin kann der Magnetfeldsensor zumindest einen Messlaser enthalten. Der Messlaser ist dazu eingerichtet, Laserstrahlung in den Diamant einzukoppeln. Weiterhin kann der Magnetfeldsensor einen Detektor enthalten, welcher dazu eingerichtet ist, die Absorption der Laserstrahlung des Messlasers im Diamant zu erfassen. Der Detektor erfasst somit das Licht des Messlasers, nachdem dieses zumindest ein Teilvolumen des Diamant zumindest einmal durchlaufen hat. Hierzu können der Messlaser einerseits und der Detektor andererseits an unterschiedlichen Enden des Resonators angeordnet sein, sodass das Licht durch teilweise transparente Spiegel des Resonators in den Diamant ein- und ausgekoppelt wird. In anderen Ausführungsformen der Erfindung kann der Strahlengang auch eine andere Form annehmen. Insbesondere kann das Licht seitlich in den Diamant ein- und/oder ausgekoppelt werden. In einigen Ausführungsformen der Erfindung kann das Licht des Messlasers den Resonator und damit den im Strahlengang angeordneten Diamant mehrfach durchlaufen, ehe es auf den Detektor fällt. Hierdurch wird die Absorption zumindest einer Resonatormode im Diamant bestimmt.

In einigen Ausführungsformen der Erfindung ist der Messlaser dazu eingerichtet, Laserstrahlung mit einer Wellenlänge von etwa 750 nm bis etwa 1040 nm zu erzeugen. In anderen Ausführungsformen der Erfindung ist der Messlaser dazu eingerichtet, Laserstrahlung mit einer Wellenlänge von etwa 1044 nm bis etwa 1500 nm zu erzeugen. In wiederum anderen Ausführungsformen der Erfindung kann der Messlaser Licht mit einer Wellenlänge von etwa 750 nm bis etwa 1040 nm und von etwa 1044 nm bis etwa 1300 nm erzeugen. Anders als bei bekannten Magnetfeldsensoren regt der Messlaser somit nicht die Singulett-Zustände [1]A und [1]E an. Die Wellenlänge ist absichtlich so gewählt, dass diese nicht der Resonanz der Singulett-Zustände entspricht.

In einigen Ausführungsformen der Erfindung kann der optische Resonator eine Finesse von mehr als 200 aufweisen. Hierdurch werden optische Verluste bei der Durchführung der Messung minimiert, sodass die Sensitivität erhöht sein kann. Der angegebene Wert der Finesse versteht sich dabei für einen optischen Reso¬na¬tor, in welchem sich während der Bestimmung der Finesse der Dia¬mant befindet. Der Einfluss des Diamant auf die Finesse ist somit im angegebenen Wert enthalten.

Der vorgeschlagene Magnetfeldsensor beruht somit anders als der Stand der Technik nicht auf dem Nachweis von Photolumineszenz bzw. von ausgesandtem rotem Licht, sondern auf der sich mit dem äußeren Magnetfeld ändernden Absorption infraroter Strahlung. Hierdurch kann die Sensitivität wesentlich erhöht werden, obwohl der verwendete infrarote Wellenlängenbereich des Messlasers kein bekanntes Energieniveau des NV-Zentrums resonant be- oder entvölkern kann. Zur Durchführung einer Messung muss dem Diamant lediglich Pumplicht zugeführt werden. Dies kann in einigen Ausführungsformen der Erfindung im Dauerstrichbetrieb der Pumplichtquelle erfolgen. Sodann kann die Absorption der infraroten Strahlung des Messlasers mittels des zumindest einen Detektors nachgewiesen werden. Nach Kalibrierung kann die Absorption ins Verhältnis zum einwirkenden Magnetfeld gesetzt werden. Der verwendete Messaufbau ist einfach und weist überraschend eine höhere Sensitivität auf als bekannte Sensoren, welche Lumineszenzstrahlung auswerten, welche vom Diamant ausgeht.

In einigen Ausführungsformen der Erfindung kann der optische Resonator eine Finesse von mehr als 300 aufweisen. In anderen Ausführungsformen der Erfindung kann der optische Resonator eine Finesse von mehr als 500 aufweisen. In wiederum anderen Ausführungsformen der Erfindung kann der optische Resonator eine Finesse von mehr als 1000 aufweisen. Der angegebene Wert der Finesse versteht sich dabei für einen optischen Reso¬na¬tor, in welchem sich während der Messung der Finesse der Dia¬mant befindet. Im Allgemeinen wird die Anwesenheit des Diamant die Eigenschaften des Resonators verschlechtern und die Finesse verringern. Der Einfluss des Diamant auf die Finesse ist somit in den angegebenen Werten enthalten.

In einigen Ausführungsformen der Erfindung kann der optische Resonator eine Finesse von weniger als 8000 aufweisen. In anderen Ausführungsformen der Erfindung kann der optische Resonator eine Finesse von weniger als 4000 aufweisen. In wiederum anderen Ausführungsformen der Erfindung kann der optische Resonator eine Finesse von weniger als 3000 aufweisen. Hierdurch kann der optische Resonator Gesamtverluste von etwa 3,1 % bis etwa 0,02 % aufweisen. Ein solcher optischer Resonator kann die Sensitivität der Magnetfeldmessung weiter erhöhen. Auch in diesem Fall bezieht sich der angegebene Wert der Finesse aus einen optischen Reso¬na¬tor, in welchem sich während der Messung der Finesse bzw. der Gesamtverluste der Dia¬mant befindet.

In einigen Ausführungsformen der Erfindung kann der Messlaser dazu eingerichtet sein, Laserstrahlung mit einer Wellenlänge von etwa 750 nm bis etwa 1300 nm zu erzeugen. In anderen Ausführungsformen der Erfindung kann der Messlaser dazu eingerichtet sein, Laserstrahlung mit einer Wellenlänge von etwa 800 nm bis etwa 1500 nm zu erzeugen. In wiederum anderen Ausführungsformen der Erfindung kann der Messlaser dazu eingerichtet sein, Laserstrahlung mit einer Wellenlänge von etwa 800 nm bis etwa 1300 nm zu erzeugen. Dabei ist jeweils ein Wellenlängenbereich von etwa 1012 nm bis etwa 1072 nm oder von etwa 1022 nm bis etwa 1062 nm oder von etwa 1035 nm bis etwa 1049 nm oder von 1041 nm bis 1043 nm ausgeschlossen. Hierdurch regt der Messlaser die Singulett-Zustände [1]A und [1]E nicht an.

In einigen Ausführungsformen der Erfindung ist der Messlaser dazu eingerichtet, kein Licht mit einer Wellenlänge von etwa 982 nm bis etwa 942 nm zu erzeugen. In anderen Ausführungsformen der Erfindung ist der Messlaser dazu eingerichtet, kein Licht mit einer Wellenlänge etwa 992 nm bis etwa 932 nm zu erzeugen. In wiederum anderen Ausführungsformen der Erfindung ist der Messlaser dazu eingerichtet, kein Licht mit einer Wellenlänge von etwa 905 nm bis etwa 919 nm zu erzeugen.

In einigen Ausführungsformen der Erfindung kann der Messlaser dazu eingerichtet sein, Laserstrahlung mit einer Wellenlänge von etwa 750 nm bis etwa 1000 nm zu erzeugen. In anderen Ausführungsformen der Erfindung kann der Messlaser dazu eingerichtet sein, Laserstrahlung mit einer Wellenlänge von etwa 800 nm bis etwa 1000 nm zu erzeugen.

In einigen Ausführungsformen der Erfindung kann der optische Resonator durch Beschichtung des Diamants mit zumindest einer Spiegelschicht hergestellt sein. Hierdurch ergibt sich ein besonders einfacher mechanisch robuster Aufbau.

In einigen Ausführungsformen der Erfindung kann der optische Resonator eine einstellbare Resonanzfrequenz aufweisen. In einigen Ausführungsformen der Erfindung kann dies durch Bewegung eines Spiegels entlang der Längsachse des Resonators erfolgen, beispielsweise durch eine Mikrometerschraube oder einen Piezosteller. Hierdurch können die Resonatormoden an die Wellenlänge des Messlasers angepasst und dadurch die Messgenauigkeit und/oder die Sensitivität weiter erhöht werden.

In einigen Ausführungsformen der Erfindung kann der Diamant eine Hintergrund-Absorption von etwa 0,1 cm[-1] oder besser aufweisen. Durch die geringe Absorption elektromagnetischer Strahlung im Diamant kann die Finesse des mit dem Diamant versehenen optischen Resonators erhöht sein.

In einigen Ausführungsformen der Erfindung kann die Absorption elektromagnetischer Strahlung im Diamant im Wellenlängenbereich von etwa 680 nm bis etwa 760 nm kleiner als etwa 0,2 cm$^{-1}$ oder kleiner als etwa 0,1 cm$^{-1}$ oder kleiner als etwa 0,05 cm$^{-1}$ oder kleiner als etwa 0,01 cm$^{-1}$ sein. Der Absorptionskoeffizient kann durch eine UV-VIS-Spektroskopie gemessen werden. Die Messung kann unter Verwendung einer Ulbricht-Kugel zur Detektion des transmittierten Lichtes durchgeführt werden. Die Reflektion an der Oberfläche des Substrates aufgrund des Unterschiedes der Brechungsindizes wird dabei berücksichtigt.

In einigen Ausführungsformen der Erfindung kann die Absorption elektromagnetischer Strahlung im Diamant im Wellenlängenbereich von etwa 680 nm bis etwa 760 nm größer als etwa 0,001 cm$^{-1}$ sein.

In einigen Ausführungsformen der Erfindung kann der Diamant eine Konzentration von NV$^-$-Zentren von 0,5 ppm oder höher aufweisen. Hierdurch wird das Signal-/Rauschverhältnis der Messung weiter erhöht, woraus eine höhere Genauigkeit und/oder eine höhere Sensitivität bei der Messung von Magnetfeldern erzielt werden kann.

In einigen Ausführungsformen der Erfindung kann der verwendete Diamant NV$^-$-Zentren in einer Konzentration von weniger als etwa 10,0 ppm oder von weniger als etwa 3,0 ppm oder von weniger als etwa 2,5 ppm oder von weniger als etwa 2,0 ppm enthalten. Die Konzentration der NV$^-$-Zentren kann jedoch größer sein als etwa 1 ppm oder größer als etwa 1,5 ppm.

In einigen Ausführungsformen der Erfindung kann der Diamant ein Volumen von etwa 100 μm × 100 μm x 300 μm oder größer aufweisen. Hierdurch kann das für die Messung zur Verfügung stehende Volumen vergrößert sein, sodass die Sensitivität erhöht sein kann.

In einigen Ausführungsformen der Erfindung kann der Magnetfeldsensor weiterhin zumindest eine HF-Einrichtung aufweisen, mit welcher Mikrowellenstrahlung zumindest am Ort des Diamant erzeugbar ist. In einigen Ausführungsformen der Erfindung kann die Mikrowellenstrahlung eine Frequenz von etwa 2,77 GHz bis etwa 2,97 GHz aufweisen. In einigen Ausführungsformen der Erfindung kann die Frequenz der Mikrowellenstrahlung während der Messung verändert werden. Dieses Merkmal bewirkt, dass innerhalb des Grundzustandes $^3$A Elektronen aus dem Grundzustand mit der Spinquantenzahl 0 in den angeregten Zustand mit der Spinquantenzahl ± 1 angeregt werden. Da die Entartung der Spinzustände +1 und -1 bei Anwesenheit eines Magnetfeldes aufgehoben wird, kann die Höhe eines Magnetfeldes aus der energetischen Aufspaltung der beiden Energieniveaus bestimmt werden.

Bei der Bestimmung eines Magnetfeldes mit dem erfindungsgemäßen Magnetfeldsensor kann die Sensitivität zwischen etwa 8 $\mathrm{pT}/\sqrt{Hz}$ bis etwa 40 $\mathrm{pT}/\sqrt{Hz}$ betragen. Somit ist eine genauere Bestimmung des Magnetfeldes gegenüber bekannten Verfahren möglich.

In einigen Ausführungsformen der Erfindung kann das Verfahren zur Erfassung eines Magnetfeldes bei Raumtempertaur durchgeführt werden. In einigen Ausführungsformen der Erfindung kann das Verfahren zur Erfassung eines Magnetfeldes bei einer Temperatur von mehr als 260 K oder mehr als 280 K durchgeführt werden. Hierdurch wird der mit der Erzeugung kryogener Temperaturen verbundene Aufwand eingespart.

Nachfolgend soll die Erfindung anhand von Figuren und Ausführungsbeispielen ohne Beschränkung des allgemeinen Erfindungsgedankens näher erläutert werden. Dabei zeigt

Figur 1    das Termschema eines NV-Zentrums in Diamant.

Figur 2    zeigt einen erfindungsgemäßen Magnetfeldsensor gemäß einer ersten Ausführungsform.

Figur 3    zeigt einen erfindungsgemäßen Magnetfeldsensor gemäß einer zweiten Ausführungsform.

Figur 4    zeigt einen erfindungsgemäßen Magnetfeldsensor gemäß einer dritten Ausführungsform.

Figur 5    zeigt einen erfindungsgemäßen Magnetfeldsensor gemäß einer vierten Ausführungsform.

Figur 6    zeigt einen erfindungsgemäßen Magnetfeldsensor gemäß einer fünften Ausführungsform.

Figur 7    zeigt das Ergebnis einer Magnetfeldmessung mit einem vorgeschlagenen Magnetfeldsensor.

Figur 8    zeigt eine Messung optisch detektierter magnetischer Resonanz bei unterschiedlichen Wellenlängen.

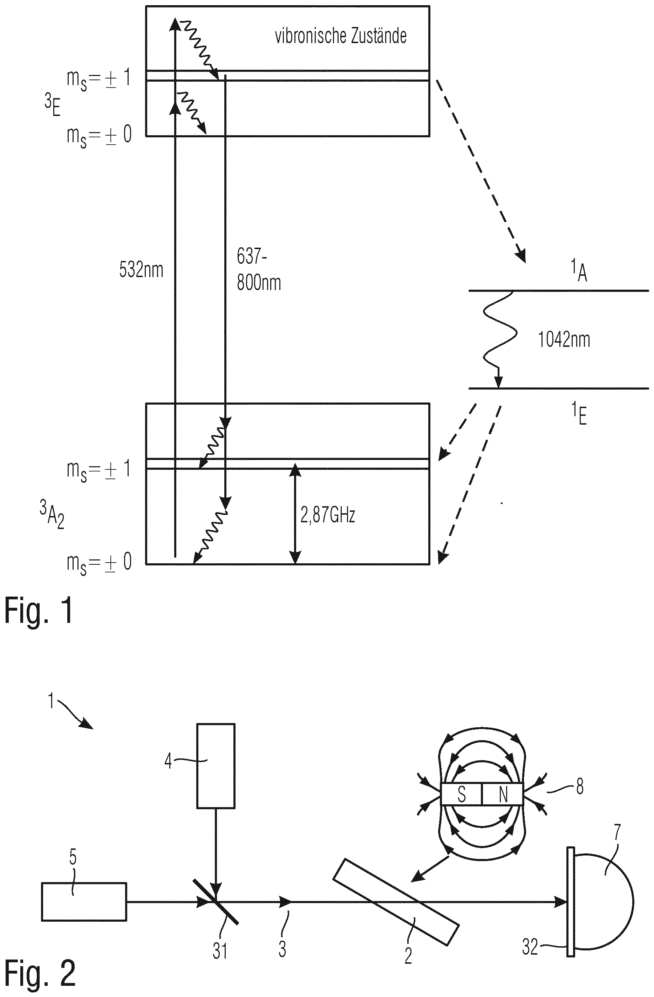

Figur 1 zeigt das Termschema eines NV-Zentrums in Diamant. Das Termschema des NV-Zentrums kann durch ein Magnetfeld beeinflusst werden. Durch Messung dieses Einflusses kann auf das Magnetfeld geschlossen werden.

Das NV-Zentrum besteht aus einem Stickstoffatom, welches statt einem Kohlenstoffatom auf einem Gitterplatz des Diamant eingebaut ist und einer benachbarten Fehlstelle im Kristallgitter. Aus Messungen der Elektronspinresonanz ist bekannt, dass das NV-Zentrum eine gerade Anzahl von Elektronen mit einem Gesamtspin von 1 besitzt. Sowohl der Grundzustand $^3$A als auch der angeregte Zustand $^3$E bilden somit einen Triplet-Zustand. Der Elektronenspin dieses Zustandes kann die Werte -1, 0 und +1 annehmen. Bei Abwesenheit eines äußeren Magnetfeldes sind die Energieniveaus des Zustandes +1 und des Zustandes -1 entartet. Die Anwesenheit eines Magnetfeldes führt zur Aufspaltung dieser Niveaus, da sich der Gesamtspin parallel oder antiparallel zum Feldvektor ausrichten kann. Wie aus Fig. 1 weiter ersichtlich ist, liegen die Energieniveaus der Zustände mit Spin ±1 ohne äußeres angelegtes Magnetfeld oberhalb des Energieniveaus des Zustandes mit Spin 0.

Durch Zufuhr von Pumplicht aus einer Pumplichtquelle 4 können Elektronen vom Grundzustand $^3$A in den angeregten Zustand $^3$E angehoben werden. Das hierzu verwendete Pumplicht kann aus dem grünen Spektralbereich gewählt sein und beispielsweise eine Wellenlänge von etwa 532 nm bis etwa 550 nm oder von etwa 480 nm bis etwa 637 nm aufweisen.

Der angeregte Zustand $^3$E zerfällt strahlend unter Aussendung roten Lichtes mit einer Wellenlänge von etwa 637 nm bis etwa 800 nm. Alternativ zerfällt der angeregte Zustand mit der Spinquantenzahl ±1 über die Singletzustände $^1$A und $^1$E in den Grundzustand $^3$A.

Innerhalb des Grundzustandes $^3$A können Elektronen aus dem Grundzustand mit der Spinquantenzahl 0 in den angeregten Zustand mit der Spinquantenzahl ±1 angeregt werden. Hierzu kann hochfrequente Strahlung eines Radiofrequenzsenders 6 verwendet werden, welcher eine Frequenz von etwa 2,88 GHz aufweist. Diese Frequenz ändert sich bei Anwesenheit eines externen Magnetfeldes, wenn die Entartung der Spinzustände +1 und -1 aufgehoben wird. Daher kann nach dem Stand der Technik ein Magnetfeld bestimmt werden, indem dem aktiven Medium kontinuierlich Pumplicht zugeführt und Fluoreszenzlicht bestimmt wird, während die Frequenz der elektromagnetischen Strahlung geändert wird. Der so erreichbare Kontrast beträgt 22% oder weniger.

Gemäß einem Aspekt der Erfindung wurde erkannt, dass infrarotes Licht mit einer Wellenlänge von etwa 750 nm bis etwa 1040 nm und/oder von etwa 1044 nm bis etwa 1500 nm vom Diamant absorbiert wird, wenn durch Zufuhr von Pumplicht aus einer Pumplichtquelle 4 Elektronen vom Grundzustand $^3$A in den angeregten Zustand $^3$E angehoben wurden. Diese Absorption weist ebenfalls eine Abhängggkeit vom Spinzustand des NV-Zentrums auf, d.h. die Absorption ist von einem am Ort des NV-Zentrums herrschenden Magnetfeld beeinflussbar. Somit kann die spinabhängige induzierte Absorption zur Magnetfeldmessung verwendet werden, wobei ein Kontrast von 50% oder mehr erreicht werden kann. Die spinabhängige induzierte Absorption hat somit das Potential, die Sensitivität eines Magnetfeldsensors zu verbessern.

Figur 2 zeigt einen Magnetfeldsensor 1 gemäß einer ersten Ausführungsform der Erfindung. Der Magnetfeldsensor 1 enthält einen Diamant 2. Der Diamant 2 kann poly- oder monokristallin sein. Der Diamant 2 ist bevorzugt, aber nicht zwingend, nominell undotiert. Der Diamant 2 kann die Form eines Quaders aufweisen und beispielsweise ein Volumen von etwa 100 x 100 um x 300 um oder mehr aufweisen. In einigen Ausführungsformen der Erfindung weist der Diamant eine hohe Kristallqualität auf, woraus sich eine Hintergrund-Absorption von etwa 0,1 cm$^{-1}$ oder besser zumindest im grünen und infraroten Spektralbereich bis etwa 1500 nm ergibt.

Weiterhin enthält der Diamant NV-Zentren, welche in an sich bekannter Weise durch ein Stickstoffatom gebildet werden, welches auf einem Gitterplatz anstelle eines Kohlenstoffatoms eingebaut ist. Ein zum Stickstoffatom benachbarter Gitterplatz weist eine Fehlstelle auf. Die zur Magnetfeldmessung verwendeten NV-Zentren sind negativ geladen, wobei der Diamant in einigen Ausführungsformen der Erfindung eine NV$^-$-Konzentration von 0,5 ppm oder mehr aufweist.

Der Diamant befindet sich in einem optischen Resonator 3, welcher durch einen ersten Spiegel 31 und einen zweiten Spiegel 32 gebildet wird. Die Spiegel können plan oder konkav geformt sein. Die Spiegel können teildurchlässig sein, sodass ein Teil eintreffender Strahlung reflektiert und ein anderer Teil transmittiert wird. Im dargestellten Ausführungsbeispiel ist der erste Spiegel 31 geneigt angeordnet, um auf diese Weise gleichzeitig eine Funktion als Strahlteiler auszuüben, um die Laserstrahlen der nachstehend beschriebenen Pumplaser 4 und Messlaser 5 zusammenzuführen. Der optische Resonator 3 weist in einigen Ausführungsformen der Erfindung eine hohe Resonatorgüte bzw. Finesse auf, welche beispielsweise mehr als 200, mehr als 300, mehr als 500 oder mehr als 1000 betragen kann.

Während des Betriebs des Magnetfeldsensors 1 wird dem Diamant 2 Pumplicht aus einem Pumplaser 4 zugeführt. Der Pumplaser 4 ist dazu eingerichtet, Laserstrahlung mit einer Wellenlänge von etwa 480 nm bis etwa 637 nm zu erzeugen. Im dargestellten Ausführungsbeispiel wird das Pumplicht aus dem Pumplaser 4 am ersten Spiegel 31 reflektiert und entlang der Längsachse des optischen Resonators 3 in diesen eingekoppelt.

Weiterhin umfasst der Magnetfeldsensor 1 einen Messlaser 5, welcher Laserstrahlung erzeugt, welche durch den teiltransparenten ersten Spiegel 31 in gerader Linie in den optischen Resonator 3 eingekoppelt wird. Der Messlaser erzeugt Laserstrahlung, welche eine Wellenlänge von etwa 750 nm bis etwa 1040 nm und/oder von etwa 1044 nm bis etwa 1500 nm aufweist. Die Laserstrahlung des Messlasers 5 durchläuft den Diamant 2 einmal oder auch mehrfach und trifft dann auf einen Detektor 7, welcher hinter dem ebenfalls teiltransparenten zweiten Spiegel 32 angeordnet ist. Der Detektor 7 kann die Schwächung der Laserstrahlung aus dem Messlaser 7 erfassen.

Wenn der Diamant 2 einem Magnetfeld ausgesetzt ist, welches mittels der Magnetfelderzeugungseinrichtung 8 erzeugt wird, ist die Absorption der Laserstrahlung des Messlasers 5 umso größer, je größer das magnetische Feld ist. Dementsprechend wird die Absorption der Laserstrahlung des Messlasers 5 schwächer, wenn das magnetische Feld abnimmt. Somit kann durch Erfassung der Intensität der Laserstrahlung des Messlasers 5 mittels des Detektors 7 das Magnetfeld bestimmt werden.

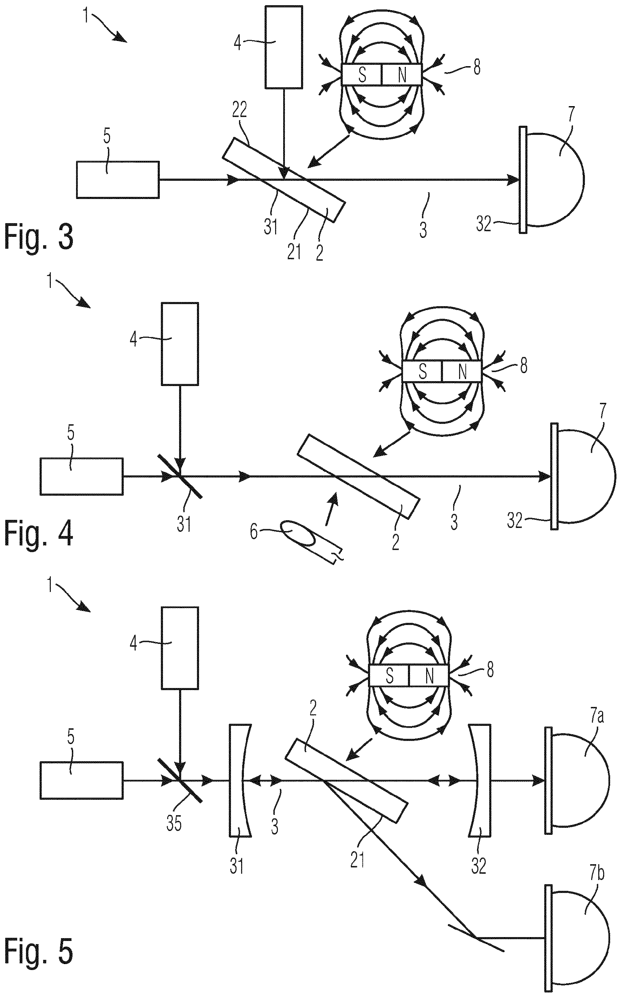

Anhand der Figuren 3 bis 6 werden weitere Ausführungsform der Erfindung näher erläutert. Gleiche Bestandteile der Erfindung sind mit gleichen Bezugszeichen versehen, sodass sich die nachfolgende Beschreibung auf die wesentlichen Unterschiede beschränkt.

Figur 3 zeigt eine zweite Ausführungsform der Erfindung. Der Resonator 3 gemäß der zweiten Ausführungsform enthält einen zweiten Spiegel 32, welcher als planarer, teildurchlässiger Spiegel ausgeführt ist, wie in der vorstehend beschriebenen ersten Ausführungsform. Der erste Spiegel 31 ist hingegen als Beschichtung auf der ersten Seite 21 des Diamant 2 ausgeführt. Die Laserstrahlung des Messlasers 5 wird dabei von der ersten Seite 21 in den Diamant 2 eingekoppelt, wobei diese die den ersten Spiegel 31 bildende Beschichtung durchdringt. Das Pumplicht des Pumplasers 4 wird von der gegenüberliegenden zweiten Seite in den Diamant 2 eingekoppelt und an der den ersten Spiegel 31 bildenden Beschichtung auf der ersten Seite 21 des Diamant 2 reflektiert. Auf diese Weise kann der Resonator 3 mit weniger Bauteilen aufgebaut werden, sodass Verluste an zusätzlichen Grenzflächen verhindert werden und die Finesse weiter ansteigt.

In einigen Ausführungsformen kann der Winkel des Diamant 2 zur Längsachse des Resonators so gewählt sein, dass das Pumplicht des Pumplasers 4 an der an der ersten Seite 21 des Diamant 2 ausgebildeten Grenzfläche totalreflektiert wird. In diesem Fall kann eine Beschichtung entfallen, sodass der erste Spiegel 31 unmittelbar durch den Diamant 2 gebildet wird.

Anhand der Figur 4 wird eine dritte Ausführungsform der Erfindung näher erläutert. Die dritte Ausführungsform unterscheidet sich von der vorstehend beschriebenen ersten Ausführungsform dadurch, dass weiterhin eine HF-Einrichtung vorhanden ist, mit welcher Mikrowellenstrahlung am Ort des Diamant 2 erzeugbar ist. Die Mikrowellenstrahlung kann eine Frequenz von etwa 2,77 GHz bis etwa 2,97 GHz aufweisen. Die Mikrowellenstrahlung dient dazu, innerhalb des Grundzustandes $^3$A Elektronen aus dem Grundzustand mit der Spinquantenzahl 0 in den angeregten Zustand mit der Spinquantenzahl ± 1 anzuregen. Da die Entartung der Spinzustände +1 und -1 bei Anwesenheit eines Magnetfeldes aufgehoben wird, kann hierdurch die Sensitivität des Messverfahrens weiter erhöht werden.

Anhand der Figur 5 wird eine vierte Ausführungsform des Magnetfeldsensors 1 näher erläutert. Die vierte Ausführungsform unterscheidet sich von der ersten Ausführungsform durch einen Resonator 3, welcher durch einen ersten Spiegel 31 und einen zweiten Spiegel 32 begrenzt ist, wobei die ersten und zweiten Spiegel 31 und 32 jeweils konkav geformt sind.

Reflektiertes Licht wird somit von den ersten und zweiten Spiegeln auf einen Brennpunkt in der Mitte des optischen Resonators 3 fokussiert. Hierdurch kann sich die Resonatorgüte bzw. die Finesse weiter verbessern, sodass der optische Resonator Gesamtverluste von etwa 0,02 % bis etwa 3,1 % aufweist. Der Diamant 2 kann im Brennpunkt der Spiegel angeordnet sein.

Während in den vorstehend beschriebenen Ausführungsformen der erste Spiegel 31 gleichzeitig als Strahlteiler fungiert, um das Licht des Pumplasers 4 und des Messlasers 5 in einem Strahlengang zusammenzuführen, verwendet die anhand der Figur 5 beschriebene vierte Ausführungsform einen separaten Strahlteiler 35 in Form eines zum Strahlengang geneigten, teiltransparenten Spiegels oder Prismas.

Schließlich zeigt Figur 5 einen ersten Detektor 7a und einen zweiten Detektor 7b. Der erste Detektor 7a erfasst eine Resonatormode, welche durch den teiltransparenten zweiten Spiegel 32 ausgekoppelt wird. Demgegenüber erfasst der zweite Detektor 7b Licht, welches an der ersten Seite 21 des Diamant 2 reflektiert wird. Beide Detektoren erfassen somit Licht, welches den Diamant 2 durchlaufen und dabei teilweise absorbiert wurde, sodass das Messsignal beider Detektoren als Maß für das einwirkende Magnetfeld dienen kann. Die Verwendung von zwei Detektoren weist den Vorteil auf, dass die Messwerte beider Detektoren plausibilisiert werden können, um auf diese Weise die Genauigkeit der Magnetfeldmessung zu erhöhen. Es ist darauf hinzuweisen, dass in einigen Ausführungsformen der Detektor 7a auch entfallen kann, sodass der zweite Detektor 7b als alleiniger Detektor die Absorption des Lichtes des Messlasers 5 im Diamant 2 erfasst.

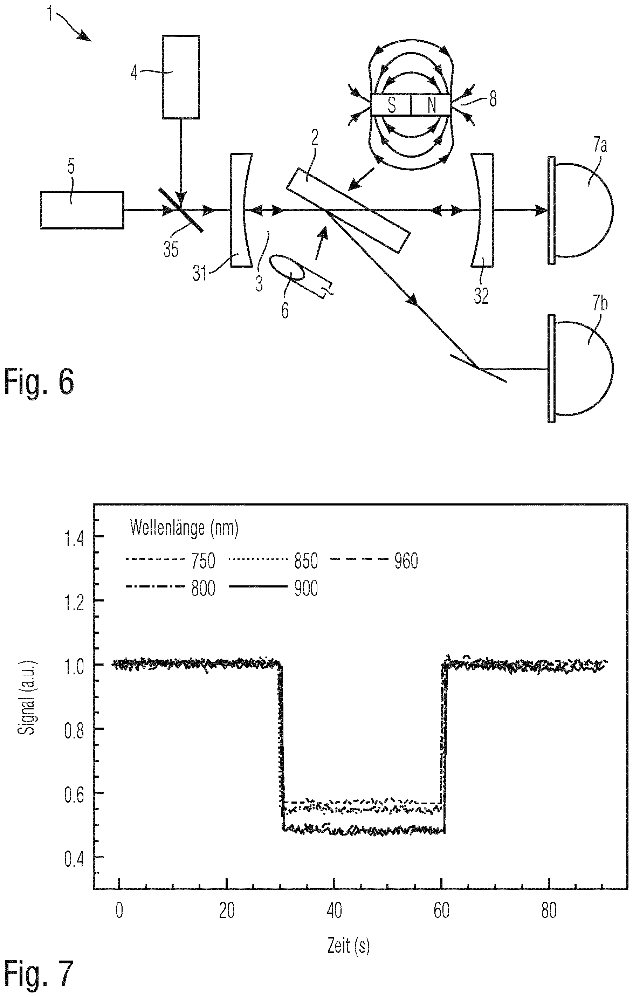

Anhand der Figur 6 wird eine fünfte Ausführungsform näher erläutert. Die fünfte Ausführungsform entspricht im Wesentlichen der vierten Ausführungsform, welche anhand der Figur 5 näher erläutert wurde, wobei die bereits in der dritten Ausführungsform erläuterte HF-Einrichtung 6 zur Verfügung steht, um die Sensitivität und/oder die Messgenauigkeit weiter zu erhöhen.

Figur 7 zeigt ein Messsignal, welches mit dem vorstehend beschriebenen Magnetfeldsensor aufgenommen wurde. Dargestellt ist die Signalintensität im Detektor 7 auf der Ordinate und die Zeit auf der Abszisse. Hierbei liegt in den ersten 30 Sekunden kein Magnetfeld an, sodann wird der Diamant 2 für 30 Sekunden einem Magnetfeld ausgesetzt. Nach 60 Sekunden wird das Magnetfeld wieder ausgeschaltet.

Dargestellt ist in die Intensität der vom Messlaser 5 ausgesandten infraroten Strahlung für unterschiedliche Wellenlängen, nämlich für 750 nm, für 800 nm, für 850 nm, für 900 nm und für 960 nm. Wie Figur 7 zeigt, bewirkt die Anwesenheit eines Magnetfeldes eine Schwächung des Signals durch Absorption im Diamant um mindestens 40 %. Bei einigen Wellenlängen liegt sogar eine Schwächung um 50 % vor. Der so ermittelte Kontrast der Messung ist mindestens um einen Faktor 2 höher als bei bekannten Magnetfeldsensoren, bei welchen das vom Diamant ausgehende Fluoreszenzlicht erfasst wird.

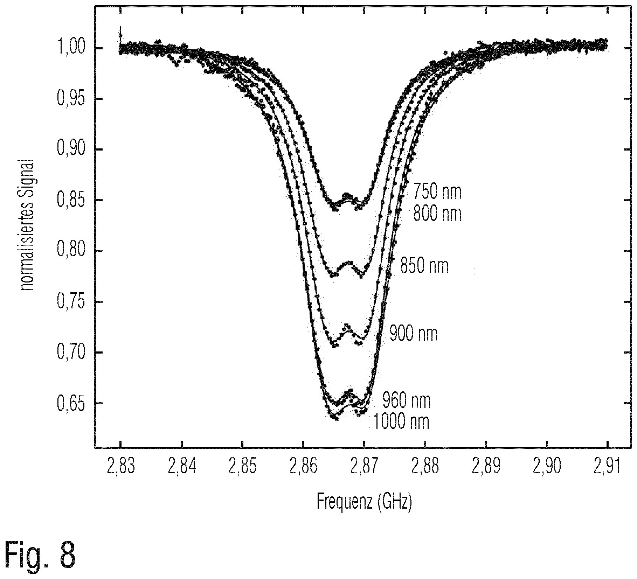

Figur 8 zeigt die optisch detektierte magnetische Resonanz bei unterschiedlichen Wellenlängen. Dargestellt ist wiederum die Intensität des vom Messlaser 5 ausgehenden Lichtes, nachdem dieses im Diamant 2 zumindest teilweise absorbiert wurde auf der Ordinate und die Frequenz einer HF-Einrichtung 6 auf der Abszisse. Erkennbar ist wiederum, dass die Absorption für Wellenlängen oberhalb des Fluoreszenzlichtes besonders groß ist.

Selbstverständlich ist die Erfindung nicht auf die dargestellten Ausführungsformen beschränkt. Die vorstehende Beschreibung ist daher nicht als beschränkend, sondern als erläuternd anzusehen. Die nachfolgenden Ansprüche sind so zu verstehen, dass ein genanntes Merkmal in zumindest einer Ausführungsform der Erfindung vorhanden ist. Dies schließt die Anwesenheit weiterer Merkmale nicht aus. Sofern die Ansprüche und die vorstehende Beschreibung "erste" und "zweite" Ausführungsformen definieren, so dient diese Bezeichnung der Unterscheidung zweier gleichartiger Ausführungsformen, ohne eine Rangfolge festzulegen.

**Patentansprüche**

1. Magnetfeldsensor (1) mit

   zumindest einem Diamant (2), welcher zumindest ein NV⁻-Zentrum enthält und
   mit zumindest einem optischen Resonator (3), in welchem der Diamant (2) angeordnet ist, sowie mit zumindest einem Pumplaser (4), welcher dazu eingerichtet ist, den Diamant mit Laserstrahlung mit einer Wellenlänge von etwa 480 nm bis etwa 637 nm zu beleuchten, und mit zumindest einem Messlaser (5), welcher dazu eingerichtet ist, Laserstrahlung in den Diamant (2) einzukoppeln, wobei weiterhin zumindest ein Detektor (7) vorhanden ist, welcher dazu eingerichtet ist, die Absorption der Laserstrahlung des Messlasers (5) im Diamant (2) zu erfassen,
   **dadurch gekennzeichnet, dass**
   der Messlaser (5) dazu eingerichtet ist, Laserstrahlung mit einer Wellenlänge von etwa 750 nm bis 1040 nm und/oder von 1044 nm bis etwa 1500 nm zu erzeugen und der optische Resonator (3) eine Finesse von mehr als 200 aufweist.

2. Magnetfeldsensor nach Anspruch 1, **dadurch gekennzeichnet, dass** der optische Resonator (3) eine Finesse von mehr als 300 oder mehr als 500 oder mehr als 1000 aufweist und/oder

   dass der optische Resonator (3) eine Finesse von weniger als 8000 oder weniger als 4000 oder weniger als 3000 aufweist und/oder dass der optische Resonator (3) Gesamtverluste von etwa 3,09 % bis etwa 0,02 % aufweist.

3. Magnetfeldsensor nach Anspruch 1 oder 2, **dadurch gekennzeichnet, dass** der Messlaser (5) dazu eingerichtet ist, Laserstrahlung mit einer Wellenlänge von etwa 750 nm bis etwa 1300 nm oder von etwa 800 nm bis etwa 1500 nm oder von etwa 800 nm bis etwa 1300 nm zu erzeugen, wobei jeweils ein Wellenlängenbereich von etwa 1012 nm bis etwa 1072 nm oder von etwa 1022 nm bis etwa 1062 nm oder von etwa 1035 nm bis etwa 1049 nm oder von 1041 nm bis 1043 nm ausgeschlossen ist.

4. Magnetfeldsensor nach einem der Ansprüche 1 oder 2, **dadurch gekennzeichnet, dass** der Messlaser (5) dazu eingerichtet ist, Laserstrahlung mit einer Wellenlänge von etwa 750 nm bis etwa 1000 nm oder von etwa 800 nm bis etwa 1000 nm zu erzeugen.

5. Magnetfeldsensor nach einem der Ansprüche 1 bis 4,

   **dadurch gekennzeichnet, dass** der optische Resonator (3) durch Beschichtung des Diamant (2) mit zumindest einer Spiegelschicht hergestellt ist oder
   dass der optische Resonator (3) eine einstellbare Resonanzfrequenz aufweist.

6. Magnetfeldsensor nach einem der Ansprüche 1 bis 5,

   **dadurch gekennzeichnet, dass** der Diamant (2) eine Hintergrund-Absorption von etwa 0.1 cm⁻¹ oder besser aufweist und/oder
   dass der Diamant (2) eine NV⁻-Konzentration von 0.5 ppm oder höher aufweist und/oder
   dass der Diamant (2) ein Volumen von etwa $100\mu m \times 100\mu m \times 300pm$ oder mehr aufweist.

7. Magnetfeldsensor nach einem der Ansprüche 1 bis 6, weiterhin enthaltend eine HF-Einrichtung (6), mit welcher Mikrowellenstrahlung am Ort des Diamant (2) erzeugbar ist.

8. Verfahren zur Erfassung eines Magnetfeldes mit zumindest einem Diamant (2), welcher zumindest ein NV⁻-Zentrum enthält und welcher in einem optischen Resonator (3) angeordnet ist, wobei der Diamant (2) mit Laserstrahlung mit einer Wellenlänge von etwa 480 nm bis etwa 637 nm beleuchtet wird, und die Absorption des Diamant (2) bei einer davon verschiedenen Wellenlänge gemessen wird, **dadurch gekennzeichnet, dass** die Absorption des Diamant (2) bei einer Wellenlänge von etwa 750 nm bis etwa 1040 nm und/oder von etwa 1044 nm bis etwa 1500 nm gemessen wird, wobei der optische Resonator (3) eine Finesse von mehr als 200 aufweist.

9. Verfahren nach Anspruch 8, **dadurch gekennzeichnet, dass** die Absorption des Diamant (2) bei einer Wellenlänge von etwa 750 nm bis etwa 1300 nm oder von etwa 800 nm bis etwa 1500 nm oder von etwa 800 nm bis etwa 1300 nm gemessen wird, wobei jeweils ein Wellenlängenbereich von etwa 1012 nm bis etwa 1072 nm oder von etwa 1022 nm bis etwa 1062 nm oder von etwa 1035 nm bis etwa 1049 nm ausgeschlossen ist.

10. Verfahren nach Anspruch 9, **dadurch gekennzeichnet, dass** die Absorption des Diamant (2) bei einer Wellenlänge von etwa 750 nm bis etwa 1000 nm oder von etwa 800 nm bis etwa 1000 nm gemessen wird.

11. Verfahren nach einem der Ansprüche 8 bis 10, **dadurch gekennzeichnet, dass** der Diamant (2) mit Mikrowellenstrahlung mit einer Frequenz von etwa 2,77 GHz bis etwa 2,97 GHz beaufschlagt wird.

12. Verfahren nach einem der Ansprüche 8 bis 11, **dadurch gekennzeichnet, dass** dieses eine Sensitivität von etwa 8 pT/sqrt(Hz) bis etwa 40 pT/sqrt(Hz) aufweist.

13. Verfahren nach einem der Ansprüche 8 bis 12, **dadurch gekennzeichnet, dass** die Resonanzfrequenz des optischen Resonators (3) zyklisch verändert wird.

**vibronische Zustände**

$m_S = \pm 1$

$^3E$

$m_S = \pm 0$

532nm

637-800nm

$^1A$

1042nm

$^1E$

$m_S = \pm 1$

$^3A_2$

2,87GHz

$m_S = \pm 0$

## Fig. 1

## Fig. 2

Fig. 3

Fig. 4

Fig. 5

Fig. 6

Fig. 7

Fig. 8

Europäisches Patentamt
European Patent Office
Office européen des brevets

# EUROPÄISCHER RECHERCHENBERICHT

**Nummer der Anmeldung**

EP 24 20 0184

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | JENSEN K ET AL: "Cavity-enhanced room-temperature magnetometry using absorption by nitrogen-vacancy centers in diamond", ARXIV.ORG, CORNELL UNIVERSITY LIBRARY, 201 OLIN LIBRARY CORNELL UNIVERSITY ITHACA, NY 14853, 10. Januar 2014 (2014-01-10), XP080001403, DOI: 10.1103/PHYSREVLETT.112.160802 * das ganze Dokument * - - - - - | 1-13 | INV. G01R33/26 G01R33/32 |
| A | GEORGIOS CHATZIDROSOS ET AL: "Miniature cavity-enhanced diamond magnetometer", ARXIV.ORG, CORNELL UNIVERSITY LIBRARY, 201 OLIN LIBRARY CORNELL UNIVERSITY ITHACA, NY 14853, 7. Juni 2017 (2017-06-07), XP080768164, DOI: 10.1103/PHYSREVAPPLIED.8.044019 * das ganze Dokument * - - - - - | 1-13 | |
| A,D | HAHL F ET AL: "Magnetic-Field-Dependent Stimulated Emission from Nitrogen-Vacancy Centres in Diamond", ARXIV.ORG, CORNELL UNIVERSITY LIBRARY, 201 OLIN LIBRARY CORNELL UNIVERSITY ITHACA, NY 14853, 10. September 2021 (2021-09-10), XP091053264, * chapter 2; Abbildung 1 * - - - - - -/-- | 1,8 | RECHERCHIERTE SACHGEBIETE (IPC) G01R |

Der vorliegende Recherchenbericht wurde für alle Patentansprüche erstellt

| Recherchenort | Abschlußdatum der Recherche | Prüfer |
|---|---|---|
| München | 28. Januar 2025 | Skalla, Jörg |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
................................................................
& : Mitglied der gleichen Patentfamilie, übereinstimmendes Dokument

EPO FORM 1503 03.82 (P04C03)

**EP 4 524 594 A1**

Europäisches Patentamt
European Patent Office
Office européen des brevets

# EUROPÄISCHER RECHERCHENBERICHT

**Nummer der Anmeldung**

EP 24 20 0184

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | JOHN F BARRY ET AL: "Sensitivity Optimization for NV-Diamond Magnetometry", ARXIV.ORG, CORNELL UNIVERSITY LIBRARY, 201 OLIN LIBRARY CORNELL UNIVERSITY ITHACA, NY 14853, 28. Mai 2020 (2020-05-28), XP081663273, DOI: 10.1103/REVMODPHYS.92.015004 * chapter V.F * - - - - - | 1-13 | |
| T | Schall Florian ET AL: "High-contrast absorption magnetometry in the visible to near-infrared range with nitrogen-vacancy ensembles", Internet , 6. Dezember 2024 (2024-12-06), Seiten 1-11, XP093243518, Internet DOI: 10.1364/OE.550716 Gefunden im Internet: URL:https://arxiv.org/abs/2412.07798 [gefunden am 2025-01-27] * das ganze Dokument * - - - - - | | **RECHERCHIERTE SACHGEBIETE (IPC)** |

Der vorliegende Recherchenbericht wurde für alle Patentansprüche erstellt

| Recherchenort | Abschlußdatum der Recherche | Prüfer |
|---|---|---|
| München | 28. Januar 2025 | Skalla, Jörg |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
...................................................................................
& : Mitglied der gleichen Patentfamilie, übereinstimmendes
    Dokument

EPO FORM 1503 03.82 (P04C03)

Seite 2 von 2

14

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **FELIX A. HAHL et al.** Magnetic-field-dependent stimulated emission from nitrogen-vacancy centers in diamond. *Sci. Adv.*, 2022, vol. 8, eabn7192